# EUROPÄISCHE PATENTSCHRIFT

(11) **EP 2 013 922 B1**
(45) Veröffentlichungstag und Bekanntmachung des Hinweises auf die Patenterteilung: **01.07.2009**
(21) Anmeldenummer: 07728215.0
(22) Anmeldetag: 18.04.2007
(51) Int. Cl.: H01L 41/053, F02M 51/06, H01L 41/083

(54) **PIEZOAKTORMODUL MIT EINER UMMANTELUNG UND EIN VERFAHREN ZU DESSEN HERSTELLUNG**
PIEZOELECTRIC ACTUATOR MODULE HAVING A SHEATH, AND A METHOD FOR PRODUCING SAID MODULE
MODULE D'ACTIONNEUR PIÉZOÉLECTRIQUE AVEC GAINE ET SON PROCÉDÉ DE FABRICATION

(30) Priorität: 21.04.2006 DE 102006018703; 08.03.2007 DE 102007011315
(43) Veröffentlichungstag der Anmeldung: 14.01.2009
(73) Patentinhaber: Robert Bosch GmbH, 70442 Stuttgart (DE)
(72) Erfinder: HEINZ, Rudolf, 71272 Renningen (DE); KIENZLER, Dieter, 71229 Leonberg (DE); SCHAICH, Udo, 70378 Stuttgart (DE); PAUER, Thomas, 71691 Freiberg (DE)
(86) Internationale Anmeldenummer: PCT/EP2007/053753
(87) Internationale Veröffentlichungsnummer: WO 2007/122149

(56) Entgegenhaltungen:
- EP-A2- 0 319 038
- WO-A-20/04006348
- WO-A-20/06106016
- DE-A1- 19 753 930
- US-A- 4 553 059

## Beschreibung

### Stand der Technik

Die Erfindung betrifft ein ummanteltes, beispielsweise von flüssigen Medien umströmtes Piezoaktormodul und ein Verfahren zu dessen Herstellung, nach den gattungsgemäßen Merkmalen der nebengeordneten Hauptansprüche.

Es ist an sich bekannt, dass zum Aufbau des zuvor erwähnten Piezoaktormoduls Piezoelemente so eingesetzt werden können, dass unter Ausnutzung des sogenannten Piezoeffekts eine Steuerung des Nadelhubes eines Ventils oder dergleichen vorgenommen werden kann. Piezolagen der Piezoelemente sind aus einem Material mit einer geeigneten Kristallstruktur so aufgebaut, dass bei Anlage einer äußeren elektrischen Spannung eine mechanische Reaktion des jeweiligen Piezoelements erfolgt, die in Abhängigkeit von der Kristallstruktur und der Anlagebereiche der elektrischen Spannung einen Druck oder Zug in eine vorgebbare Richtung darstellt. Derartige aus Piezoelementen gebildete Piezoaktoren eignen sich beispielsweise für Anwendungen, bei denen Hubbewegungen unter hohen Betätigungskräften und hohen Taktfrequenzen ablaufen.

Beispielsweise ist ein solches Piezoaktormodul als Bestandteil eines Piezoinjektors aus der DE 10026005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktormodul ist ein Stapel mehrerer elektrisch und mechanisch miteinander gekoppelter Piezoelemente so aufgebaut, das der Stapel über einen Aktorfuß und einen Aktorkopf unter Vorspannung zwischen zwei Anschlägen gehalten ist. Jede piezokeramische Piezolage ist zur Bildung des Piezoelements zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Solche bekannten Anordnungen werden häufig zur Einbringung von Kraftstoff in direkt einspritzende Dieselmotoren als sogenannte Common Rail Systeme eingesetzt. Bei diesen bekannten Systemen kann dabei der Einspritzdruck auf einfache Weise an die Last und Drehzahl des Verbrennungsmotors angepasst werden.

Diese Common Rail Injektoren können dabei so aufgebaut werden, dass eine indirekt vom Piezoaktor gesteuerte Düsennadel vorhanden ist, wobei das Piezoaktormodul direkt oder indirekt vom Druck des Kraftstoffs umgeben ist und zwischen der Düsennadel und dem Piezoaktormodul lediglich ein hydraulischer Kopplungsraum vorgesehen ist. Hierbei ist es wichtig, dass der relativ empfindliche Piezoaktor im Inneren eines Haltekörpers vor einer zu großen Druckbelastung bzw. vor Druck- oder Temperaturschwankungen geschützt wird. Zusätzlich ist auch noch ein Schutz vor mechanischem Stoß oder Druck insbesondere hinsichtlich der elektrischen Isolierung und ein Schutz vor Feuchtigkeit (Diesel, Wasser, RM E oder sonstige elektrisch leitende Substanzen), Partikel oder Schwebstoffen notwendig.

Um eine elektrische und mechanische Isolierung des Piezoaktors zu erreichen, wird oft eine Ummantelung des Piezoaktors vorgeschlagen. Aus der DE 10230032 A1 ist zur Vermeidung der zuvor beschriebenen Nachteile eine Anordnung mit einem Piezoaktor in umströmenden Medien bekannt, bei der die Piezoelemente in einer formveränderlichen Isolationsmasse vergossen sind, die wiederum in einem seitlich und am oberen und unteren Ende gegenüber dem Medium fest verschlossenen Gehäusemantel eingebracht ist.

Für sich gesehen ist es aus einer Reihe von Anwendungen bekannt, dass mit einer elastischen Kunststoffumspritzung der Piezoaktor zum Beispiel bei einem direkt schaltenden Piezoinjektor, bei dem das Piezoaktormodul direkt dem Hochdruck des Kraftstoffzulaufs ausgesetzt ist, vor den zuvor erwähnten schädlichen Einflüssen geschützt werden kann. Bei diesen direkt schaltenden Piezoinjektoren sitzt zwischen dem Piezoaktormodul und der Düsennadel lediglich ein mechanischer Koppler mit einer hydraulischen Übersetzung, so dass die Nadelbewegung direkt übersetzt der Bewegung des Piezoaktors folgt, wobei hier auch zweistufige Übersetzungen möglich sind.

Bei diesen bekannten Anordnungen besteht immer das Problem der Abdichtung des Beschichtungswerkstoffs, in der Regel Kunststoff, mit den Anbindungsteilen aus Stahl, wie dem Aktorkopf und dem Aktorfuß an den Stirnseiten der Piezoelemente des Piezoaktors. Diese Abdichtung kann meist nur klebend hergestellt werden bzw. es ist die Anbindung auf die Haftfestigkeit des Beschichtungsmaterials auf den Stahlteilen angewiesen.

Die bei einer indirekten Steuerung der Düsennadel bekannten Anordnungen mit einem Piezoaktormodul im Niederdruckbereich des Kraftstoffs weisen Metallhülsenabdichtung auf, die hier als hub- und temperaturausgleichendes Element eingesetzt werden können. Diese Anordnungen sind jedoch nicht auf Anwendungen mit direkter Steuerung der Düsennadel übertragbar. Aufgrund der Konstruktion mit einem Piezoaktormodul im Hochdruckbereich bei der direkten Steuerung würde hier eine starre Metallhülsenabdichtung den hohen Systemdrucken und höheren Hubbewegungen des Piezoaktors unter den zur Verfügung stehenden Platzverhältnissen nicht standhalten.

Ein Piezoaktormodul mit einer Umhüllung gemäß dem Oberbegriff des Anspruchs 1 ist aus DE 197 53 930 A1 bekannt.

### Offenbarung der Erfindung

Die Erfindung geht von einem eingangs beschriebenen Piezoaktormodul mit einem Mehrschichtaufbau von Piezoelementen als Piezoaktor aus, wobei zwischen Piezolagen der Piezoelemente angeordnete Innenelektroden in Richtung des Lagenaufbaus des Piezoelements abwechselnd mit einer unterschiedlichen Polarität einer elektrischen Spannung beaufschlagt sind. Es ist hierzu ein Aktorfuß und ein Aktorkopf aus Stahl vorhanden und es muss zum Schutz vor den umströmenden Medien ein mindestens die Piezoelemente umgebendes elastisches Isolationsmedium vorhanden sein. Erfindungsgemäß ist in vorteilhafter Weise am Aktorfuß und/oder am Aktorkopf mindestens eine ringförmige Nut oder Ausnehmung vorhanden, in die ein sowohl mit dem Stahl als auch mit einem Schlauch oder Hülse aus Kunststoff als Isolationsmedium verbind- oder vernetzbarer Stoff eingebracht ist.

Das Material des Schlauchs oder der Hülse lässt sich nicht direkt mit Stahl hochdruckdicht über die geforderte Lebensdauer verbinden, da diese unterschiedliche Wärmeausdehnungskoeffizienten haben und dadurch Scherkräften auftreten, die zu Schubrissen und zu Undichtheiten führen. Ein solcher Schlauch erzielt die nötige Dichtwirkung gegenüber den Piezoelementen und stellt zusätzlich einen Hub- und Temperaturdehnungsausgleich bei -40 bis +160°C sicher.

Wenn zum Beispiel erfindungsgemäß ein Polymer oder Elastomer als Stoff auf das Stahlteil aufvulkanisiert wird, lässt sich der Schlauch oder die Hülse an den offenen Enden mittels Wärmeeinwirkung, wie UV-Licht, Laser oder Ofenerwärmung, mit dem Stoff verbinden oder vernetzen. Mit der Erfindung können die jeweiligen Materialien speziell nach Ihren Anforderungen ausgelegt werden. Das bedeutet, dass das Polymer oder Elastomer für das Vulkanisieren speziell bezüglich der Wärmedehnung und Haftfestigkeit auf den Stahl abgestimmt werden kann.

Es ist somit mit einer kostengünstigen, einfachen und dauerhaftes Abdichtung der Schlauchenden ein Medieneintritt über die Lebensdauer des Piezoaktors verhindert.

Vorteilhaft weisen die Nuten oder Ausnehmungen einen rechteckigen oder auch einen trapezförmigen, nach innen sich aufweitenden Querschnitt auf, damit der Halt des vorzugsweise auf den Stahl des Kopf- oder Fußteils aufvulkanisierbaren Stoffs im Aktorfuß oder im Aktorkopf verbessert ist.

Die Verbindungsflächen der Nuten oder Ausnehmungen am Aktorfuß und/oder am Aktorkopf mit dem Stoff können in vorteilhafter Weise zur Erhöhung der wirksamen Oberfläche eine jeweils korrespondierende Verzahnung aufweisen, die eine dreieckige, rechteckige oder eine Bogen- oder Pyramidenkontur oder Kreuz-, Quer- oder Längsrillen aufweisen. Vorteilhaft ist auch, wenn zwischen dem Aktorfuß und/oder dem Aktorkopf und dem Stoff ein Ringträger mit der jeweiligen Kontur für die Aufnahme des Stoffes auf der Außenseite vorhanden ist.

Die zuvor erwähnten Verbindungsflächen und Oberflächenstrukturen können in ihrer Form, Dicke und Breite je nach Materialwahl und Platzverhältnissen gestaltet werden.

Bei einem vorteilhaften Herstellungsverfahren des zuvor beschriebenen Piezoaktors wird zunächst am Aktorfuß und am Aktorkopf vor dem Zusammenbau des Piezoaktormoduls jeweils in eine ringförmige Nut zum Beispiel ein schweißbarer Kunststoff oder eine schweißbare Kunststoff-Gummimischung eingebracht. Der Piezoaktor kann mit dem Aktorfuß und dem Aktorkopf sowie dem dazwischenliegenden Piezoelementen zusammengefügt werden. Es kann dann über den Piezoaktor ein flexibler, schweißbarer Kunststoffschlauch gezogen und an einem Ende verbunden oder vernetzt, insbesondere verschweißt werden.

Gemäß einer Ausführung des Verfahrens wird und nun am anderen Ende ein Vakuum erzeugt und unter dem Vakuum wird das andere Ende des Kunststoffschlauchs mit dem dortigen Kunststoff oder der Kunststoff-Gummimischung in der Nut verschweißt. Die Bildung des Vakuums kann hierbei beispielsweise gleichzeitig eine Dichtheitsprüfung für die erste Schweißnaht und eventuell den Kunststoffschlauch darstellen.

Gemäß einer andern Ausführung des Verfahrens wird ein flexibler, schweißbarer schrumpfender Kunststoffschlauch über den Piezoaktor gezogen und der Kunststoffschlauch wird an einem Ende verschweißt und durch Schrumpfen an den Piezoaktor angedrückt. Das andere Ende des Kunststoffschlauchs kann dann auch hier mit dem dortigen Kunststoff oder der Kunststoff-Gummimischung in der Nut verschweißt werden.

Es können dabei auch die Merkmale der beiden zuvor erwähnten Varianten kombiniert werden, wobei in allen Fällen leicht sichergestellt werden kann, dass die Beschichtung des Piezoaktors nahezu vollkommen luftleer an der Geometrie des Piezoaktors anliegt, damit sie die eventuell hohen Drücke des umströmenden Mediums abstützen kann und nicht reißt. Ferner kann hiermit auch gewährleistet werden, dass die Beschichtung die Dehnung durch den Hub des Piezoaktors im Betrieb elastisch ausgeglichen werden kann.

Auf einfache Weise können nach der vollständigen Verschweißung des Kunststoffschlauchs mit dem Kunststoff oder Kunststoff-Gummimischung in den Nuten die überstehende Enden des Kunststoffschlauchs mechanisch mit einem geeigneten Scheidewerkzeug entfernt werden.

Die Erfindung ist vor allem deswegen vorteilhaft zu realisieren, da bei der Verwendung von Stahlbauteilen für den Aktorfuß und den Aktorkopf sich relativ leicht gute Stahl-Kunststoffverbindungen herstellen lassen, die aus der Vulkanisationstechnik für sich gesehen bekannt sind. Da ein solches Verfahren bei einer Beschichtung des Piezoelements durch die relativ hohen Vulkanisiertemperaturen nachteilig ist, kann mit der erfindungsgemäßen separaten Anbindung am Aktorfuß und/oder am Aktorkopf dieser Vorgang getrennt von der Montage des Piezoaktors vorgenommen werden.

Weiter vorteilhafte Ausgestaltungen der Erfindung sind in den Unteransprüchen angegeben.

### Kurze Beschreibung der Zeichnungen

Ausführungsbeispiele des erfindungsgemäßen Piezoaktormoduls werden anhand der Zeichnungen erläutert. Es zeigen:
- Figur 1: einen Schnitt durch Teile eines Piezoinjektors mit einem ummantel- ten Piezoaktormodul mit einem Aktorkopf, Piezoelementen als Pie- zoaktor und einem Aktorfuß in einem Schlauch aus Kunststoff,
- Figur 2: eine detaillierte Ansicht der Verbindungsstelle zwischen dem Schlauch nach der Figur 1 und einem mit dem Schlauch verbind- o- der vernetzbaren Stoff in einer Nut des Aktorfußes,
- Figur 3: eine detaillierte Ansicht der Verbindungsstelle nach der Figur 1 mit einem verbind- oder vernetzbaren Stoff in einer Ausnehmung des Ak- torfußes und einer Schweißstelle,
- Figur 4: eine Abwandlung der Darstellung nach der Figur 3 mit einer Verzah- nungskontur zwischen dem Stoff in der Ausnehmung und dem Aktor- fuß,
- Figur 5: mögliche Verzahnungskonturen für die Ausführung nach der Figur 4,
- Figur 6: eine Abwandlung der Darstellung nach der Figur 4 mit einem Ring- träger,
- Figur 7: eine Schweißverbindung zwischen dem Ringträger nach der Figur 6 und dem Aktorfuß,
- Figuren 8 bis 11: verschiedene Ausführungen der Schweißstelle nach der Figur 3 und
- Figuren 12 bis 14: verschiedene Ausführungen der Nuten mit einer Kammerung des verbind- oder vernetzbaren Stoffs in der Nut des Aktorfußes.

### Ausführungsformen der Erfindung

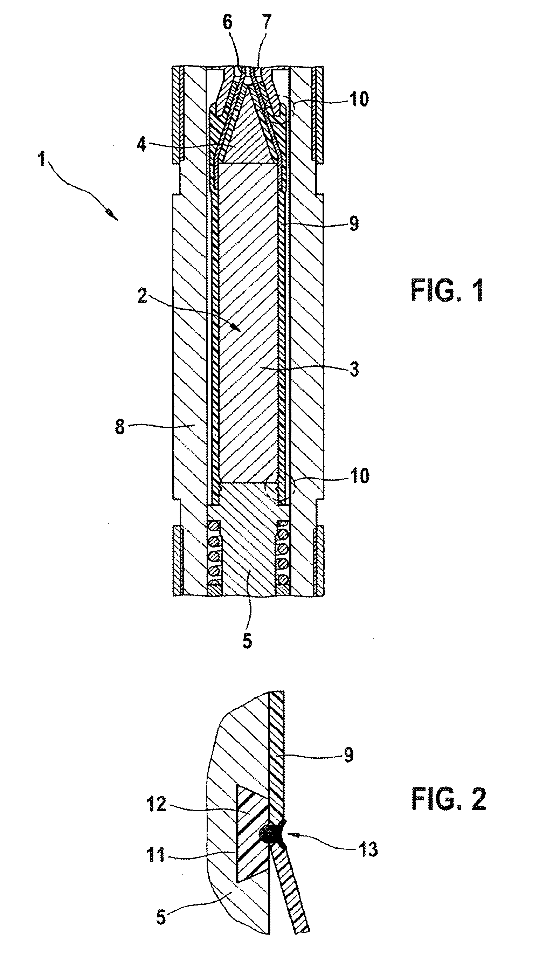

In Figur 1 ist eine Anordnung 1 als Ausschnitt aus einem Piezoinjektor mit einem Piezoaktormodul gezeigt, die beispielsweise zur Nadelhubsteuerung im Einspritzsystem für Kraftstoff bei einem Verbrennungsmotor eingesetzt werden kann. Piezoelemente 3 sind Bestandteil des Piezoaktors 2, der zur Bildung des Piezoaktormoduls weiterhin noch einen Aktorfuß 4 und einen Aktorkopf 5 aus Stahl aufweist. Es sind elektrische Zuleitungen 6 und 7 durch den Aktorfuß 4 geführt, die über Außenelektroden an hier nicht dargestellten Innenelektroden an den Piezoelementen 3 kontaktiert sind. Bei einer Betätigung des Piezoaktors 2 durch eine Spannungsbeaufschlagung der Innenelektroden kann eine hier senkrecht unterhalb des Aktorkopfes 5 befindliche mechanische Anordnung derart betätigt werden, dass hier eine Freigabe einer Düsenöffnung des Einspritzsystems erfolgen kann.

Die Anordnung 1 mit dem Piezoaktor 2 ist in einem hier nur teilweise gezeigten Injektorkörper 8 eingebaut, wobei der Kraftstoff durch den Innenraum des Injektorkörpers am Piezoaktormodul vorbeigeführt wird. Dieser Kraftstoff kann dann beispielsweise bei einem sogenannten Common Rail System unter dem in der Beschreibungseinleitung erwähnten Raildruck oder einem anderen vorgebbaren Druck in den Brennraum eines hier nicht dargestellten Verbrennungsmotors injiziert werden.

Um den Piezoaktor 2 vor dem umströmenden Kraftstoff und vor sonstigen schädlichen Einwirkungen zu schützen, ist ein schweißbarer Schlauch 9 aus Kunststoff, Gummi oder einem Gemisch der beiden Stoffe vorhanden, der insbesondere die empfindlichen Piezoelemente 3 fest umschließt und außerdem mit dem Aktorfuß 4 und dem Aktorkopf 5 über eine unten noch näher erläuterte Verschweißung 10 verbunden ist.

Aus Figur 2 ist die Verschweißung 10 am Aktorfuß 4 oder am Aktorkopf 5 im Detail zu entnehmen, wobei hier eine ringförmige Nut 11, hier am Aktorfuß 5, mit einem trapezförmigen Querschnitt vorhanden ist, in die ein schweißbarer Stoff 12 wie Gummi, Kunststoff, z.B. ein Polymer oder Elastomer, oder ein Gemisch dieser Stoffe einvulkanisiert ist.

Zur Herstellung dieses zuvor beschriebenen Piezoaktormoduls wird der Piezoaktor 2 nach dem Einvulkanisieren des Stoffes 12 mit dem Aktorfuß 4, dem Aktorkopf 5 zusammengefügt. Es wird dann über den Piezoaktor 2 der flexible, schweißbare Schlauch 9 gezogen und an einem Ende, beispielsweise am Aktorfuß 4 mit dem Stoff 12 in der Nut 11 mit einer Schweißnaht 13 verschweißt.

Gemäß einer ersten Variante kann am anderen Ende, hier der Aktorkopf 5, ein Vakuum erzeugt werden und unter dem Vakuum wird das andere Ende des Schlauchs 9 mit dem dortigen Stoff 12 in der Nut 11 ebenfalls unter Bildung einer Schweißnaht 13 verschweißt. Andererseits kann der Schlauch 9 auch ein schrumpfender Kunststoffschlauch sein, der durch Schrumpfen an den Piezoaktor 2 angedrückt wird.

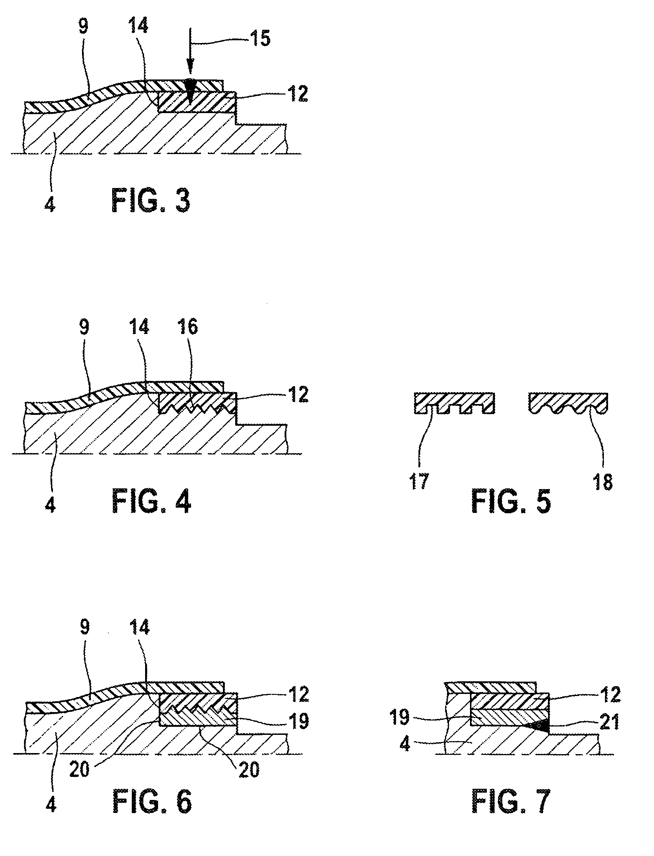

Aus Figur 3 ist entnehmbar, wie der Stoff 12 in einer Ausnehmung 14 des Aktorfußes 5 einvulkanisiert ist. Mit einem Pfeil 15 ist angedeutet, dass hier eine Vernetzung des Schlauches 9 mit dem Stoff 12 zum Beispiel mittels einer Laserverschweißung vorgenommen wird.

Figur 4 zeigt in Verbindung mit Figur 5, wie eine Vergrößerung der Verbindungsflächen zwischen dem Stoff 12 und dem Aktorfuß 4 aus Stahl durch eine dreieckige Verzahnungskontur 16, eine rechteckige Verzahnungskontur 17 oder eine gewölbten Kontur 18 hergestellt werden kann. Weiterhin sind hier nicht dargestellte dreidimensionale Pyramidenkonturen oder auch Kreuz-, Quer- oder Längsrillen möglich.

In Figur 6 ist die zusätzliche Anordnung eines Ringträgers 19 zwischen dem Stoff 12 und den Aktorfuß 4 gezeigt, der beispielsweise an den Bereichen 20 verklebt oder gemäß Figur 7 über eine Schweißnaht 21 mit dem Aktorfuß 4 verbunden werden kann.

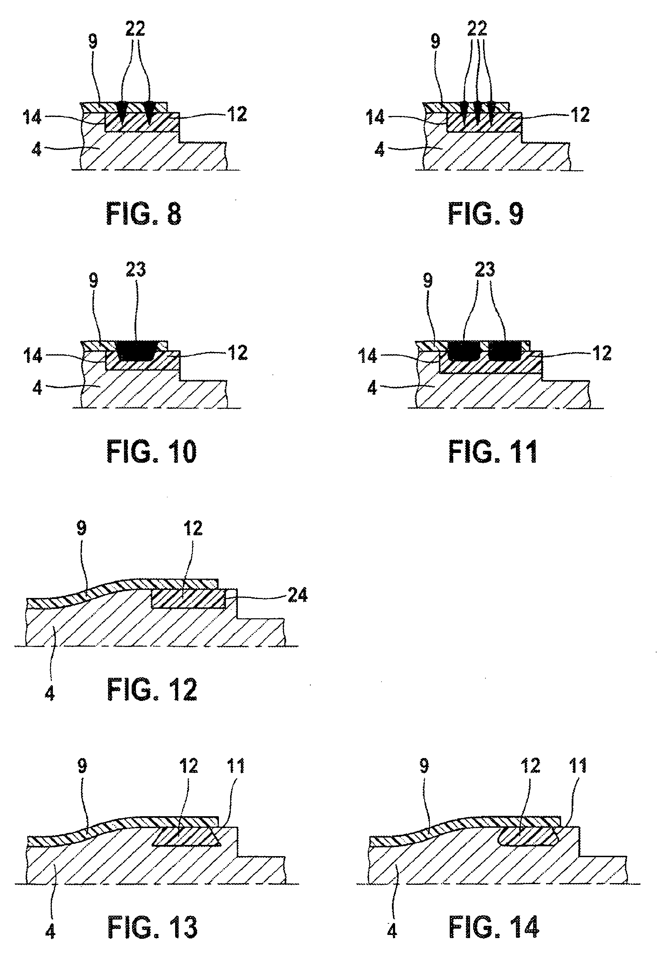

Figur 8 bis 11 zeigen verschiedene Ausführungen von Vernetzungsgeometrien gemäß dem Pfeil 15 nach der Figur 3, wobei die Figur 8 eine zweispurige und die Figur 9 eine mehrspurige, keilförmige und somit schmale und tiefe Vernetzungsgeometrie 22 zeigt. Die Figur 10 zeigt eine einfache und die Figur 11 eine zweispurige, in etwa rechteckförmige und somit breite und flache Vernetzungsgeometrie 23.

Aus Figur 12 ist ein erstes Beispiel für eine Kammerung des verbind- oder vernetzbaren Stoffs 12 in einer rechteckigen Nut 24 des Aktorfußes 4 entnehmbar und Figur 13 und 14 zeigen Ausführungen der trapezförmigen Nut 11 vergleichbar mit Figur 2, die bei der Figur 14 an den Ecken jeweils leicht abgerundet ist.

## Patentansprüche

1. Piezoaktormodul mit einem Mehrschichtaufbau von Piezoelementen (3) als Piezoaktor (2), wobei zwischen Piezolagen der Piezoelemente (3) angeordnete Innenelektroden in Richtung des Lagenaufbaus des Piezoaktors (2) abwechselnd mit einer unterschiedlichen Polarität einer elektrischen Spannung beaufschlagt sind, mit einem Aktorfuß (4) und einem Aktorkopf (5) aus Stahl und mit einem mindestens die Piezoelemente (3) umgebenden in vorgegebenen Grenzen elastischen Isolationsmedium, und mit mindestens einer am Aktorfuß (4) und/oder am Aktorkopf (5) ringförmigen Nut (11;24) oder Ausnehmung (14) **dadurch gekennzeichnet, dass** in diese Nuten oder Ausnehmungen ein mit dem Isolationsmedium verbind- oder vernetzbarer Stoff (12) eingebracht ist und dass über die Piezoelemente (3) und zumindest über die Nuten (11;24) oder Ausnehmungen (14) mit dem Stoff (12) ein flexibler Schlauch (9) als Isolationsmedium liegt, der mit dem Stoff (12) in den Nuten (11;24) oder Ausnehmungen (14) verbunden oder vernetzt ist.

2. Piezoaktormodul nach Anspruch 1, **dadurch gekennzeichnet, dass** der Stoff (12) in die Nuten (11;24) oder Ausnehmungen (14) einvulkanisiert ist.

3. Piezoaktormodul nach Anspruch 1 oder 2, **dadurch gekennzeichnet, dass** der Stoff (12) und/oder der Schlauch (9) ein flexibler Kunststoff, vorzugsweise ein Polymer oder Elastomer, ein Gummi oder eine Mischung der beiden Stoffe ist.

4. Piezoaktormodul nach Anspruch 3, **dadurch gekennzeichnet, dass** der Schlauch (9) aus einem unter Wärmeeinwirkung schrumpfbaren Kunststoff gebildet ist.

5. Piezoaktormodul nach einem der vorhergehenden Ansprüche, **dadurch gekennzeichnet, dass** die Nuten (11;24) oder Ausnehmungen (14) einen rechteckigen oder zumindest einseitig einen trapezförmigen, nach innen sich aufweitenden Querschnitt aufweisen.

6. Piezoaktormodul nach einem der vorhergehenden Ansprüche, **dadurch gekennzeichnet, dass** die Verbindungsflächen der Nuten (11;24) oder Ausnehmungen (14) am Aktorfuß (4) und/oder am Aktorkopf (5) mit dem Stoff (12) zur Erhöhung der wirksamen Oberfläche eine jeweils korrespondierende Verzahnungskontur (6,17,18) aufweisen, die eine dreieckige, rechteckige oder eine Bogen- oder Pyramidenkontur oder Kreuz-, Quer- oder Längsrillen aufweisen.

7. Piezoaktormodul nach Anspruch 5 oder 6, **dadurch gekennzeichnet, dass** zwischen dem Aktorfuß (4) und/oder dem Aktorkopf (5) und dem Stoff (12) ein Ringträger (19) vorhanden ist.

8. Piezoaktormodul nach Anspruch 7, **dadurch gekennzeichnet, dass** der Ringträger (19) mit dem Aktorfuß (4) und/oder dem Aktorkopf (5) an einer Schweißnaht (21) verschweißt oder verklebt oder weichgelötet ist.

9. Piezoaktor nach einem der vorhergehenden Ansprüche, **dadurch gekennzeichnet, dass** der flexible Schlauch (9) mit dem Stoff (12) in den Nuten (11;24) oder Ausnehmungen (14) mittels zwei- oder mehrspuriger, keil-, rechteck- oder trapezförmiger Vernetzungsgeometrien (22;23) vernetzt, vorzugsweise verschweißt ist.

10. Verfahren zur Herstellung eines Piezoaktormoduls nach einem der vorhergehenden Ansprüche, **dadurch gekennzeichnet, dass** am Aktorfuß (4)und am Aktorkopf (5) vor dem Zusammenbau jeweils in die ringförmige Nut (11;24) oder Ausnehmung (14) der mit dem Schlauch (9) der verbind- oder vernetzbare Stoff (12) eingebracht wird, dass der Piezoaktor (2) mit dem Aktorfuß (4) und dem Aktorkopf (5) zusammengefügt wird, dass über den Piezoaktor (2) und zumindest teilweise über den Aktorfuß (4)und den Aktorkopf (5) der flexible Schlauch (9) als Isolationsmedium gezogen wird und dass der Schlauch (9) an zunächst an einem Ende und dann am anderen Ende unter Wärmeeinwirkung mit dem Stoff (12) verbunden oder vernetzt wird.

11. Verfahren zur Herstellung eines Piezoaktormoduls nach Anspruch 10, **dadurch gekennzeichnet, dass** über den Piezoaktor (2) und zumindest teilweise über den Aktorfuß (4)und den Aktorkopf (5) ein flexibler schrumpfender Schlauch (9) gezogen wird, dass der Schlauch (9) an einem Ende verschweißt wird und durch Schrumpfen an den Piezoaktor (2) angedrückt wird und dass dann das andere Ende des Schlauchs (9) mit dem dortigen Stoff (12) in der Nut (11;24) oder Ausnehmung (14) verschweißt wird.

12. Verfahren nach Anspruch 10 oder 11, **dadurch gekennzeichnet, dass** am anderen Ende des Schlauchs (9) ein Vakuum erzeugt wird und dass unter dem Vakuum das andere Ende des schrumpfenden Schlauchs (9) mit dem dortigen Stoff (12) in der Nut (11;24) oder Ausnehmung (14) verschweißt wird.

13. Verfahren nach einem der Ansprüche 10 bis 12, **dadurch gekennzeichnet, dass** nach der vollständigen Verschweißung des Schlauchs (9) mit dem Stoff (12) in den Nuten (11;24) oder Ausnehmungen (14) überstehende Enden des Schlauchs (9) mechanisch entfernt werden.

14. Verwendung eines Piezoaktormoduls nach einem der vorhergehenden Ansprüche, **dadurch gekennzeichnet, dass** das Piezoaktormodul Bestandteil eines Piezoinjektors für ein Einspritzsystem für Kraftstoff bei einem Verbrennungsmotor ist, wobei der Kraftstoff den Schlauch (9) umströmt.

## Claims

1. Piezo-actuator module with a multi-layer set-up of piezo-elements (3) as a piezo-actuator (2), inner electrodes arranged between piezo-layers of the piezoelements (3) being acted upon alternately with a different polarity of an electrical voltage in the direction of the layered set-up of the piezo-actuator (2), with an actuator foot (4) and an actuator head (5) consisting of steel, and with an insulation medium which surrounds at least the piezo-elements (3) and is elastic within predetermined limits, and with at least one annular groove (11; 24) or recess (14) on the actuator foot (4) and/or on the actuator head (5), **characterized in that** a material (12) connectable to or cross-linkable with the insulation medium is introduced into these grooves or recesses, and **in that** a flexible hose (9), as insulation medium, lies over the piezoelements (3) and at least over the grooves (11; 24) or recesses (14) having the material (12) and is connected to or cross-linked with the material (12) in the grooves (11; 24) or recesses (14).

2. Piezo-actuator module according to Claim 1, **characterized in that** the material (12) is vulcanised into the grooves (11; 24) or recesses (14).

3. Piezo-actuator module according to Claim 1 or 2, **characterized in that** the material (12) and/or the hose (9) is a flexible plastic, preferably a polymer or elastomer, a rubber or a mixture of the two materials.

4. Piezo-actuator module according to Claim 3, **characterized in that** the hose (9) is formed from a plastic shrinkable under the action of heat.

5. Piezo-actuator module according to one of the preceding claims, **characterized in that** the grooves (11; 24) or recesses (14) have a rectangular or, at least on one side, a trapezoidal cross section widening inwards.

6. Piezo-actuator module according to one of the preceding claims, **characterized in that** the surfaces of connection of the grooves (11; 24) or recesses (14) on the actuator foot (4) and/or on the actuator head (5) to the material (12) have, in order to increase the effective surface, an in each case matching toothing contour (6, 17, 18) having a triangular, rectangular or arcuate or pyramidal contour or cross, transverse or longitudinal flutes.

7. Piezo-actuator module according to Claim 5 or 6, **characterized in that** a ring carrier (19) is present between the actuator foot (4) and/or the actuator head (5) and the material (12).

8. Piezo-actuator module according to Claim 7, **characterized in that** the ring carrier (19) is welded at a weld seam (21) or adhesively bonded or soft-soldered to the actuator foot (4) and/or the actuator head (5).

9. Piezo-actuator according to one of the preceding claims, **characterized in that** the flexible hose (9) is cross-linked, preferably welded, to the material (12) in the grooves (11; 24) or recesses (14) by means of two-track or multi-track wedge-shaped, rectangular or trapezoidal cross-linking geometries (22; 23).

10. Method for producing a piezo-actuator module according to one of the preceding claims, **characterized in that** the material (12) connectable or cross-linkable to the hose (9) is introduced into the annular groove (11; 24) or recess (14) in each case on the actuator foot (4) and on the actuator head (5) prior to assembly, **in that** the piezo-actuator (2) is joined together with the actuator foot (4) and the actuator head (5), **in that** the flexible hose (9) is drawn as insulation medium over the piezo-actuator (2) and at least partially over the actuator foot (4) and the actuator head (5), and **in that** the hose (9) is connected or cross-linked to the material (12) first at one end and then at the other end under the action of heat.

11. Method for producing a piezo-actuator module according to Claim 10, **characterized in that** a flexible shrinking hose (9) is drawn over the piezo-actuator (2) and at least partially over the actuator foot (4) and the actuator head (5), **in that** the hose (9) is welded at one end and is pressed by shrinkage onto the piezo-actuator (2), and **in that** the other end of the hose (9) is then welded to the material (12) located there in the groove (11; 24) or recess (14).

12. Method according to Claim 10 or 11, **characterized in that** a vacuum is generated at the other end of the hose (9), and **in that** the other end of the shrinking hose (9) is welded under the vacuum to the material (12) located there in the groove (11; 24) or recess (14).

13. Method according to one of Claims 10 to 12, **characterized in that**, after the hose (9) has been welded completely to the material (12) in the grooves (11; 24) or recesses (14), projecting ends of the hose (9) are removed mechanically.

14. Use of a piezo-actuator module according to one of the preceding claims, **characterized in that** the piezo-actuator module is an integral part of a piezo-injector for an injection system for fuel in an internal combustion engine, the fuel flowing around the hose (9).

## Revendications

1. Module d'actionneur piézoélectrique ayant une structure multicouche d'éléments piézoélectriques (3) en tant qu'actionneur piézoélectrique (2), des électrodes internes disposées entre des couches piézoélectriques des éléments piézoélectriques (3) étant sollicitées dans la direction de la structure à couches de l'actionneur piézoélectrique (2) en alternance avec une tension électrique de polarité différente, comprenant une base d'actionneur (4) et une tête d'actionneur (5) en acier et un milieu isolant élastique dans des limites prédéterminées, entourant au moins les éléments piézoélectriques (3), et comprenant au moins une rainure de forme annulaire (11 ; 24) ou un évidement (14) sur la base d'actionneur (4) et/ou la tête d'actionneur (5), **caractérisé en ce que** dans ces rainures ou ces évidements est introduite une substance (12) pouvant être liée ou réticulée à un milieu isolant, et **en ce qu'**un tuyau flexible (9) servant de milieu isolant est placé par-dessus les éléments piézoélectriques (3) et au moins par-dessus les rainures (11 ; 24) ou les évidements (14) avec la substance (12), et est lié ou réticulé à la substance (12) dans les rainures (11 ; 24) ou les évidements (14).

2. Module d'actionneur piézoélectrique selon la revendication 1, **caractérisé en ce que** la substance (12) est vulcanisée dans les rainures (11 ; 24) ou les évidements (14).

3. Module d'actionneur piézoélectrique selon la revendication 1 ou 2, **caractérisé en ce que** la substance (12) et/ou le tuyau (9) sont un plastique flexible, de préférence un polymère ou un élastomère, un caoutchouc ou un mélange des deux substances.

4. Module d'actionneur piézoélectrique selon la revendication 3, **caractérisé en ce que** le tuyau (9) est formé d'un plastique thermorétractable.

5. Module d'actionneur piézoélectrique selon l'une quelconque des revendications précédentes, **caractérisé en ce que** les rainures (11 ; 24) ou les évidements (14) présentent une section transversale rectangulaire ou au moins trapézoïdale d'un côté, s'élargissant vers l'intérieur.

6. Module d'actionneur piézoélectrique selon l'une quelconque des revendications précédentes, **caractérisé en ce que** les surfaces de liaison des rainures (11 ; 24) ou des évidements (14) présentent sur la base de l'actionneur (4) et/ou sur la tête de l'actionneur (5) avec la substance (12), pour augmenter la surface active, un contour de denture correspondant respectif (6, 17, 18), qui présente un contour triangulaire, rectangulaire ou circulaire ou pyramidal, ou des gorges croisées, transversales ou longitudinales.

7. Module d'actionneur piézoélectrique selon la revendication 5 ou 6, **caractérisé en ce qu'**entre la base d'actionneur (4) et/ou la tête d'actionneur (5) et la substance (12) est prévu un support annulaire (19).

8. Module d'actionneur piézoélectrique selon la revendication 7, **caractérisé en ce que** le support annulaire (19) est soudé ou collé ou brasé tendre à la base d'actionneur (4) et/ou à la tête d'actionneur (5) au niveau d'un joint de soudure (21).

9. Actionneur piézoélectrique selon l'une quelconque des revendications précédentes, **caractérisé en ce que** le tuyau flexible (9) avec la substance (12) est réticulé, de préférence soudé dans les rainures (11 ; 24) ou les évidements (14) au moyen de deux géométries de réticulation (22 ; 23) à deux pistes ou plus, en forme de coin, de rectangle ou de trapèze.

10. Procédé de fabrication d'un module d'actionneur piézoélectrique selon l'une quelconque des revendications précédentes, **caractérisé en ce que** sur la base d'actionneur (4) et la tête d'actionneur (5) avant l'assemblage, on introduit à chaque fois dans la rainure de forme annulaire (11 ; 24) ou l'évidement (14) la substance (12) pouvant être liée ou réticulée au tuyau (9), **en ce que** l'actionneur piézoélectrique (2) est assemblé à la base d'actionneur (4) et la tête d'actionneur (5), **en ce que** le tuyau flexible (9) en tant que milieu isolant est tiré par-dessus l'actionneur piézoélectrique (2) et au moins en partie par-dessus la base d'actionneur (4) et la tête d'actionneur (5), et **en ce que** le tuyau (9) est lié ou réticulé à la substance (12) d'abord à une extrémité puis à l'autre extrémité sous l'effet de la chaleur.

11. Procédé de fabrication d'un module d'actionneur piézoélectrique selon la revendication 10, **caractérisé en ce qu'**un tuyau flexible rétractable (9) est tiré par-dessus l'actionneur piézoélectrique (2) et au moins en partie par-dessus la base d'actionneur (4) et la tête d'actionneur (5), **en ce que** le tuyau (9) est soudé à une extrémité et est pressé par retrait sur l'actionneur piézoélectrique (2) et **en ce que** l'autre extrémité du tuyau (9) est alors soudée à la substance (12) existant dans la rainure (11 ; 24) ou l'évidement (14).

12. Procédé selon la revendication 10 ou 11, **caractérisé en ce qu'**à l'autre extrémité du tuyau (9) est généré un vide et **en ce que** sous l'effet du vide l'autre extrémité du tuyau rétractable (9) est soudée à la substance (12) existant dans la rainure (11 ; 24) ou l'évidement (14).

13. Procédé selon l'une quelconque des revendications 10 à 12, **caractérisé en ce qu'**après le soudage complet du tuyau (9) à la substance (12) dans les rainures (11 ; 24) ou les évidements (14), des extrémités du tuyau (9) qui dépassent sont enlevées mécaniquement.

14. Utilisation d'un module d'actionneur piézoélectrique selon l'une quelconque des revendications précédentes, **caractérisée en ce que** le module d'actionneur piézoélectrique fait partie d'un injecteur piézoélectrique pour un système d'injection pour du carburant dans un moteur à combustion interne, le carburant circulant autour du tuyau (9).
